# EUROPÄISCHE PATENTSCHRIFT

(11) **EP 2 952 818 B1**
(45) Veröffentlichungstag und Bekanntmachung des Hinweises auf die Patenterteilung: **30.09.2020**
(21) Anmeldenummer: 14171593.8
(22) Anmeldetag: 06.06.2014
(51) Int. Cl.: F24C 7/08, H03K 17/968

(54) **Bedienvorrichtung für ein Haushaltsgerät mit einem Bedienknebel, der einen Lichtleiter und eine Infrarot-Sende-Empfangseinrichtung aufweist**
Operating device for a domestic appliance with an operating toggle with an optical fibre, and an infra-red transmitting and receiving device
Dispositif de commande pour un appareil ménager doté d'une manette de commande, présentant un dispositif d'envoi et de réception à infrarouge et un conducteur lumineux

(43) Veröffentlichungstag der Anmeldung: 09.12.2015
(73) Patentinhaber: BSH Hausgeräte GmbH, 81739 München (DE)
(72) Erfinder: Maier, Thomas, 84518 Garching a.d. Alz (DE); Schmal, Stefan, 84101 Obersüßbach (DE); Vormann, Ingo, 83413 Fridolfing (DE); Wurnitsch, Ernst, 6382 Kirchdorf in Tirol (AT); Leinmüller, Elena, 85521 Ottobrunn (DE)

(56) Entgegenhaltungen:
- EP-B1- 2 821 709
- DE-A1-102012 200 292

## Beschreibung

Die Erfindung betrifft eine Bedienvorrichtung für ein Haushaltsgerät, mit einem Bedienelement, welches auf einer Bedienelementaufnahme des mit der Bedienvorrichtung steuerbaren Haushaltsgeräts mittels Magnetkraft haltbar ist und relativ zur Bedienelementaufnahme bewegbar und von dort abnehmbar positionierbar ist. Das Bedienelement weist einen Lichtleiter auf, welcher einen Lichteinkoppelbereich umfasst, der in dem Rand des Bedienelements ferner liegend angeordnet ist als ein Lichtauskoppelbereich des Lichtleiters. Mit derartigen Ausführungen von abnehmbaren Bedienelementen kann über den Lichtleiter geleitetes Licht von innen quasi radial nach außen geleitet werden und somit auch im Randbereich des Bedienelements abgestrahlt werden.

Eine derartige Bedienvorrichtung ist beispielsweise aus der DE 10 2011 083 460 A1 bekannt. Dort ist auch vorgesehen, dass mittels Einstellmagneten die Drehstellung des Bedienelements relativ zur Bedienfläche erfasst werden kann und abhängig davon eine gewünschte Betriebsbedingungseinstellung des Haushaltsgeräts erkannt und durchgeführt wird. Die Einstellmagnete sind im Bedienelement unter dem Lichtleiter angeordnet und treten in Wechselwirkung mit Sensoren, die in der Kochfeldplatte angeordnet sind.

Die DE 10 2012 200 292 A1 beschreibt eine Bedienvorrichtung für ein Haushaltsgerät mit einem Bedienelement. Durch Berühren des Bedienelements kann ein Benutzer eine Betriebsbedingung des Haushaltsgeräts einstellen. Hierzu sieht das Bedienelement eine Infrarot-Sende-Empfangseinheit vor, mit welcher IR-Strahlung zu einem Berührbereich aussendbar ist und mit welcher eine durch die Berührung reflektierte IR-Strahlung detektiert wird. Die nachveröffentlichte DE 10 2012 200292 A1 offenbart alle Merkmale des Oberbegriffes.

Es ist Aufgabe der vorliegenden Erfindung, eine Bedienvorrichtung zu schaffen, bei welcher ein kompakt aufgebautes Bedienelement bezüglich einer optischen Informationsdarstellung und einer Positionsbestimmung verbessert ist. Weiter ist es Aufgabe, ein Haushaltsgerät mit einer derartigen Bedienvorrichtung zu schaffen und zu verbessern.

Diese Aufgabe wird durch eine Bedienvorrichtung und einem Haushaltsgerät gemäß den Ansprüchen gelöst.

Eine erfindungsgemäße Bedienvorrichtung für ein Haushaltsgerät umfasst ein Bedienelement, welches auf einer Bedienelementaufnahme des mit der Bedienvorrichtung steuerbaren Haushaltsgeräts mittels Magnetkraft haltbar ist und relativ zur Bedienelementaufnahme bewegbar und von dort abnehmbar positionierbar ist. Das Bedienelement umfasst zumindest einen Lichtleiter, welcher einen Lichteinkoppelbereich aufweist. Der Lichteinkoppelbereich ist einem Rand des Bedienelements ferner liegend angeordnet als ein Lichtauskoppelbereich des Lichtleiters. Der Lichtleiter ist also so in dem Bedienelement angeordnet und orientiert, dass er Licht von einem einem Mittelpunkt des Bedienelements näher liegenden Bereich beziehungsweise einer entsprechend näher liegenden Stelle zu einer zu diesem Mittelpunkt weiter weg liegenden Stelle leitet und dort entsprechend abstrahlt.

Ein wesentlicher Gedanke der Erfindung ist darin zu sehen, dass die Bedienvorrichtung eine Infrarot-Sende-Empfangseinrichtung zur Bestimmung der Position des Bedienelements aufweist. Diese Infrarot-Sende-Empfangseinrichtung umfasst Sende-Empfangseinheiten, die unter dem Lichtleiter angeordnet sind und in besonders vorteilhafter Ausgestaltung zur axialen Detektion durch den Lichtleiter hindurch ausgebildet sind. Bei Betrachtung in Richtung der Längsachse deckt somit der Lichtleiter die Infrarot-Sende-Empfangseinheiten quasi von oben ab. Eine derartige Ausgestaltung ermöglicht in einer Richtung senkrecht zu einer Längsachse des Bedienelements einen besonders kompakten Aufbau, da der Lichtleiter und die Empfangseinrichtung quasi untereinander positioniert sind. Durch die Infrarot-Sende-Empfangseinrichtung wird auch ein Detektionsmechanismus geschaffen, der sehr präzise arbeitet. Auch wird durch diese Kombination der örtlichen Anordnung der Empfangseinrichtung und des Lichtleiters einerseits und der konzeptionellen Ausgestaltung der Sende-Empfangseinrichtung andererseits, nämlich auf Infrarotlichtbasis arbeitend, eine Ausgestaltung geschaffen, bei der die Infrarotstrahlung nach oben durch den Lichtleiter abgestrahlt werden kann, ohne dass das Licht im Lichtleiter dadurch beeinträchtigt werden würde, und darüber hinaus auch dann die Detektion der Infrarotstrahlung von oben durch den Lichtleiter hindurch bis zur darunterliegenden Infrarot-Sende-Empfangseinrichtung ermöglicht ist.

Es sind Lichtquellen vorgesehen, die bei Betrachtung in Richtung der Längsachse der Bedienvorrichtung in geradliniger Verlängerung unter einem Lichteinkoppelbereich des Lichtleiters angeordnet sind. Eine umfängliche anderweitige Lichtumlenkung und Zuleitung zum Lichteinkoppelbereich ist dadurch verhindert und ein möglichst kurzer Weg zwischen der Lichtquelle und dem Lichteinkoppelbereich erreicht. Die Lichtquellen in einem Ringkanal angeordnet sind, dessen Wände, die eine Trennwand und eine Wand der Einhausung vorzugsweise darstellen, mit Höhen ausgebildet sind, die größer sind als die Lichtquellenhöhen. Innenseiten dieser Trennwände beziehungsweise dieses Ringstegs der Einhausung sind teilweise reflektierend, so dass das von den Lichtquellen emittierte Licht im großen Umfange zum Lichteinkoppelbereich des Lichtleiters reflektiert wird und somit eine sehr hohe Lichtmenge des emittierten Lichts zu diesem Lichtleiter gelangt.

Vorzugsweise ist vorgesehen, dass das Bedienelement einen Boden aufweist, durch welchen der Lichtleiter von unten abgedeckt ist. Insbesondere ist vorgesehen, dass ein Lichteinkoppelbereich des Lichtleiters von unten durch den Boden abgedeckt ist. Durch eine derartige Ausgestaltung ist der Lichtleiter quasi von unten geschützt positioniert, so dass sowohl beim Abnehmen als auch Aufsetzen als auch bei einer Relativbewegung des auf die Bedienelementaufnahme aufgesetzten Bedienelements relativ zur Bedienelementaufnahme keine Beschädigung wie beispielsweise ein Verkratzen oder dergleichen des Lichtleiters erfolgen kann. Darüber hinaus ist der Lichtleiter durch eine derartige Ausgestaltung auch vor Verschmutzungen, insbesondere am Lichteinkoppelbereich, geschützt. Die Funktionssicherheit und die maximal mögliche Lichteinkopplung sind dadurch gegeben. Auch kann dies dann dauerhaft aufrecht erhalten werden. Darüber hinaus ist durch eine derartige Ausgestaltung auch das Bedienelement als solches mechanisch stabil und robust aufgebaut, da quasi ein vorzugsweise vollständig geschlossener Boden gestaltet ist, der vorzugsweise mit einem Deckel ein Gehäuse des Bedienelements bildet.

Vorzugsweise ist vorgesehen, dass das Bedienelement einen Boden aufweist, der zumindest an den Bereichen, an denen das Licht für den Lichtleiter einkoppelbar ist, und an den Bereichen, an denen die Sende-Empfangseinheiten durch den Lichtleiter detektieren, für Licht im für den Menschen sichtbaren Spektralbereich und für den Infrarotstrahlenbereich durchlässig ist. Die oben genannten Vorteile sowohl im Hinblick auf die mechanischen Aspekte als auch im Hinblick auf die optischen Aspekte sind dadurch begünstigt.

Vorzugsweise ist vorgesehen, dass der Boden aus einem Kunststoff, vorzugsweise PSU (Polysulfon) oder PESU (Polyethersulfon) ausgebildet ist. Diese sind ganz besonders vorteilhafte Kunststoffe bezüglich mechanischer und optischer Eigenschaften und sind darüber hinaus noch sehr robust gegenüber sehr stark schwankenden Temperatureinflüssen, wie dies beispielsweise bei einem Einsatz bei einem Gargerät, beispielsweise einem Kochfeld, der Fall ist.

Diese Kunststoffmaterialien sind äußerst hitzebeständig und weisen darüber hinaus jedoch auch die erforderliche Transparenz im für den Menschen sichtbaren Spektralbereich und im Infrarotstrahlenbereich auf.

Vorzugsweise ist vorgesehen, dass der Lichtleiter als ringscheibenförmiger Körper ausgebildet ist, an dessen Rand ein nach oben erhabener Steg als Lichtauskoppelbereich ausgebildet ist. Diese Ausgestaltung des Lichtleiters ermöglicht vom Lichteinkoppelbereich bis zu dem den Lichtauskoppelbereich bildenden Steg eine sehr flach bauende Ausgestaltung des Lichtleiters, die darüber hinaus durch die Ringstruktur sehr stabil und verbindungssteif ist. Durch den Steg als Lichtauskoppelbereich wird dieser geometrisch und bezüglich der Orientierung exakt definiert und bleibt in dem Zusammenhang auch dauerhaft positionell entsprechend erhalten, so dass die Richtung der Lichtabstrahlung aus dem Lichtauskoppelbereich sehr präzisiert ist.

Insbesondere ist der Lichtleiter einstückig ausgestaltet.

Vorzugsweise ist das Bedienelement mit einer Mantelwand ausgebildet, durch welche der Lichtleiter seitlich umlaufend abgedeckt ist und auf welcher ein Deckel des Bedienelements aufsitzt. Durch diese Ausgestaltung ist erreicht, dass auch seitlich der Lichtleiter vor unerwünschten Einflüssen wie einem Verkratzen oder einer Verschmutzung geschützt ist. Durch diese Seitenwand wird somit auch ein Trägerelement für weitere Komponenten des Bedienelements, die dann ein Gehäuse definieren, geschaffen. Dadurch wird die mechanisch stabile Ausgestaltung dieses Gehäuses erreicht.

Insbesondere dann, wenn die Seitenwand lichtundurchlässig ausgebildet ist, können auch unerwünschte optische Effekte und unerwünschte Lichtaustritte vermieden werden.

Vorzugsweise ist vorgesehen, dass die Sende-Empfangseinheiten jeweils seitlich umlaufend zur Vermeidung der Streulichteinstrahlung eingehaust sind. Dies ist eine sehr vorteilhafte Ausführung, da dadurch sehr gezielt und gerichtet eine möglichst große, von der Lichtquelle emittierte Lichtmenge zum Lichteinkoppelbereich des Lichtleiters geführt werden kann. Andererseits ist es vermieden, dass andere Bauteile des Bedienelements durch dieses Licht in der Funktionalität beeinträchtigt werden. Insbesondere kann dadurch auch eine unerwünschte Erwärmung von anderen Bauteilen durch das Licht der Lichtquelle vermieden werden. Insbesondere ist dadurch auch eine Separierung zu den Sende-Empfangseinheiten erreicht. Insbesondere ist als eine derartige Einhausung ein Ring vorgesehen, der die Lichtquellen in Umlaufrichtung um die Längsachse des Bedienelements umgibt. Vorzugsweise ist vorgesehen, dass dieser Ring der Einhausung in Richtung senkrecht zur Längsachse des Bedienelements betrachtet zwischen den Lichtquellen und den Sende-Empfangseinheiten angeordnet ist.

Die Lichtquellen sind vorzugsweise sehr nahe zu einem Mittelpunkt des Bedienelements angeordnet. Vorzugsweise ist dazu vorgesehen, dass zentral mittig ein Haltemagnet angeordnet ist, der vorzugsweise zylinderförmig ausgebildet ist. In radialer Richtung und somit in einer Richtung senkrecht zur Längsachse des Bedienelements und somit auch der Bedienvorrichtung ist dann eine Mehrzahl von Lichtquellen unmittelbar anschließend an diesen Haltemagneten und um diesen umlaufend positioniert. Es kann auch vorgesehen sein, dass zwischen den Lichtquellen und dem Haltemagneten eine dünne Trennwand, beispielsweise aus Kunststoff, angeordnet ist. Wie bereits erläutert, sitzt dann auf der in radialer Richtung betrachtet gegenüberliegenden Seite der Lichtquellen der Ring als Einhausung, so dass die Lichtquellen quasi in einer ringartigen Vertiefung beziehungsweise einer Nut angeordnet sind. Diese Vertiefung beziehungsweise die Höhen dieser Wände der Einhausung sind vorzugsweise so dimensioniert, dass die Lichtquellen vollständig darin versenkt sind. Die oben genannten Vorteile bezüglich der Streulichtvermeidung sind dadurch besonders hervorgehoben.

Die reflektierende Ausgestaltung der Innenseiten kann durch eine Folie oder eine entsprechende Beschichtung ausgebildet sein.

Insbesondere ist vorgesehen, dass dieser bedienelementexterne Haltemagnet und/oder eine möglicherweise vorhandene Trennwand, sowie die Lichtquellen und die optional vorhandene Einhausung außerhalb des Bedienelements, insbesondere darunter, angeordnet sind. Die Anordnung der genannten Elemente kann dabei unterhalb einer die Bedienfläche aufweisenden Haushaltsgeräteplatte, insbesondere einer Kochfeldplatte, oder zumindest bereichsweise in dieser Haushaltsgeräteplatte angeordnet sein. Auch die Sende-Empfangseinheiten sind unter oder zumindest bereichsweise in dieser Haushaltsgeräteplatte angeordnet. Vorzugsweise sind diese genannten Komponenten auf einem Schaltungsträger beziehungsweise einer Platine angeordnet, die positionell unterhalb dieser Haushaltsgeräteplatte angeordnet ist.

Vorzugsweise ist vorgesehen, dass ein Deckel eines Gehäuses des Bedienelements zumindest bereichsweise, insbesondere vollständig, aus einem Glas oder glasartigen Material ausgebildet ist. Vorzugsweise ist die Materialausgestaltung so, dass Licht hindurchtreten kann. Insbesondere ist das Material dieses Deckels ein chemisch gehärtetes Glas. Eine derartige Ausgestaltung erfüllt die Anforderungen im Hinblick auf mechanische Robustheit, Verkratzschutz und ausreichende Transparenz für die jeweiligen Spektralbereiche besonders.

Vorzugsweise ist vorgesehen, dass an einer dem Lichtleiter zugewandten Unterseite dieses Deckels eine Folie oder eine Bedruckung aufgebracht ist, die für Infrarot und Licht im für den Menschen sichtbaren Spektralbereich durchlässig ist. Vorzugsweise ist eine derartige Folie oder Bedruckung in einem Flächenbereich der Unterseite ausgebildet, der durch einen äußeren Flächenring gebildet ist.

Durch eine derartige Ausgestaltung kann das von dem Lichtauskoppelbereich radial relativ weit außen abgestrahlte Licht auch ungehindert über den Deckel aus dem Bedienelement emittiert werden. Eine optische Informationspräsentation bezüglich Betriebsbedingungseinstellungen und dergleichen kann somit einem Nutzer sehr umfänglich und leicht nachvollziehbar dargeboten werden. Entsprechend ist auch die Verarbeitung der Infrarotstrahlen über diesen Flächenbereich des Deckels dadurch begünstigt.

Vorzugsweise ist vorgesehen, dass der Deckel an den Bereichen, die bei vertikaler Betrachtung über einem Lichteinkoppelbereich angeordnet sind, lichtundurchlässig ausgebildet ist. Unerwünschte Lichtaustritte und somit unerwünschte optische Effekte oder gar fehlinterpretierbare optische Informationen über den Deckel des Bedienelements an einen Nutzer können dadurch verhindert werden. Vorzugsweise grenzt in radialer Betrachtung dieser Bereich, der für Licht undurchlässig ist, direkt an den Flächenring an, der für das Licht im sichtbaren Spektralbereich und für die Infrarotstrahlen durchlässig ist.

Vorzugsweise weist derjenige Flächenbereich der Unterseite des Deckels, der für Licht undurchlässig ausgebildet ist, Dreherkennungsmarkierungen auf, mittels denen die Drehrichtung des Bedienelements relativ zur Bedienfläche erkannt werden kann. Abhängig von einer derartigen Drehrichtungserkennung und einer entsprechenden Länge dieser Drehbewegung kann die Einstellung eines gewünschten Betriebsparameterwerts erkannt werden.

In dem Zusammenhang kann durch eine derartige Drehung des Bedienelements beispielsweise eine Kochstufe einer Kochzone eines Gargeräts eingestellt werden.

Vorzugsweise sind diese Markierungen in Umlaufrichtung um die Längsachse des Bedienelements betrachtet beabstandet und äquidistant zueinander angeordnet. Beispielsweise können diese Markierungen als weiße Bedruckungen oder Lackierungen gestaltet sein.

Bei einer bevorzugten Ausführung ist vorgesehen, dass der Deckel an den Bereichen, die bei vertikaler Betrachtung und somit bei Betrachtung in Richtung der Längsachse des Bedienelements über einem Lichteinkoppelbereich angeordnet sind, lichtundurchlässig ausgebildet ist.

Die Lichtquellen können vorzugsweise Leuchtdioden sein.

Im Bedienelement ist ebenfalls zentral und mittig ein Haltemagnet positioniert, der mit dem bedienelementexternen Haltemagnet wechselwirkt, um das Bedienelement auf der Bedienfläche zu halten. Vorzugsweise ist dieser bedienelementinterne Haltemagnet in einer Aufnahme angeordnet, die beispielsweise auch einstückig mit dem Boden gestaltet sein kann. In radialer Richtung benachbart zu diesem Haltemagneten, insbesondere anschließend an die Außenseite der Aufnahme für den Haltemagneten ist der Lichtleiter, insbesondere mit seinem Lichteinkoppelbereich, angeordnet. Er erstreckt sich vorzugsweise dann in radialer Richtung bis zu der Innenseite der genannten Mantelwand. Eine maximale radiale Lichtleitung ist dadurch ermöglicht.

Es kann darüber hinaus auch vorgesehen sein, dass das Bedienelement einen Abschlussring aufweist, der die Mantelwand und den Außenrand des Deckels umlaufend umgibt, vorzugsweise mit einem Umgriffsbereich beziehungsweise einem Kragen auf die Oberseite beziehungsweise Außenseite des Deckels zum Liegen kommt und diesen entsprechend einfassend und darauf aufsitzend kontaktiert.

Dieser Abschlussring kann beispielsweise aus Edelstahl oder Kunststoff sein, so dass er neben seiner Haltefunktion auch verschleißarm ausgestaltet ist und auch designerischen Aspekten Rechnung trägt.

Durch die spezifische Anordnung des Lichtleiters und der Infrarot-Sende- und Empfangseinrichtung kann das Infrarotsignal für die Selektion eines Teilbereichs beziehungsweise einer Teileinheit des Haushaltsgeräts, insbesondere einer Kochstelle eines Kochfelds, durch den Lichtleiter axial geleitet und dann auf dem Schaltungsträger, auf dem die Sende-Empfangseinheiten angeordnet sind, auch entsprechend ausgewertet werden. Wird in dem Zusammenhang durch einen Nutzer beispielsweise mit einem Finger vorzugsweise auf die Oberseite des Deckels des Bedienelements insbesondere eine Berührung durchgeführt, so wird an spezifischen Stellen die Auswahl einer gewünschten Teileinheit, insbesondere einer Kochzone, erkannt. Diese Auswahl kann dann durch eine örtlich spezifizierte Lichtleitung einer oder mehrerer Lichtquellen zu dem Lichtleiter optisch angezeigt werden, so dass der Nutzer auch die Auswahl dieser Teileinheit örtlich und optisch an dem Bedienelement selbst angezeigt bekommt. Die optische Anzeige über die Lichtquellen und den Lichtleiter kann zusätzlich oder anstatt dazu auch für andere Betriebsbedingungseinstellungen des Haushaltsgeräts verwendet werden.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar.

Ausführungsbeispiele der Erfindung werden nachfolgend anhand schematischer Zeichnungen näher erläutert. Es zeigen:
- Fig. 1: eine perspektivische Darstellung eines Ausführungsbeispiels eines erfindungsgemäßen Haushaltsgeräts;
- Fig. 2: eine perspektivische Schnittdarstellung des Haushaltsgeräts gemäß Fig. 1;
- Fig. 3: eine Schnittdarstellung der Ausführung in Fig. 2;
- Fig. 4: eine Draufsicht auf Teilkomponenten der Bedienvorrichtung gemäß Fig. 1 und Fig. 2, wie sie in dem Haushaltsgerät verbaut sind; und
- Fig. 5: eine Ansicht auf eine Unterseite eines Deckels des Bedienelements der Bedienvorrichtung gemäß Fig. 2 und 3.

In den Figuren werden gleiche oder funktionsgleiche Elemente mit den gleichen Bezugszeichen versehen.

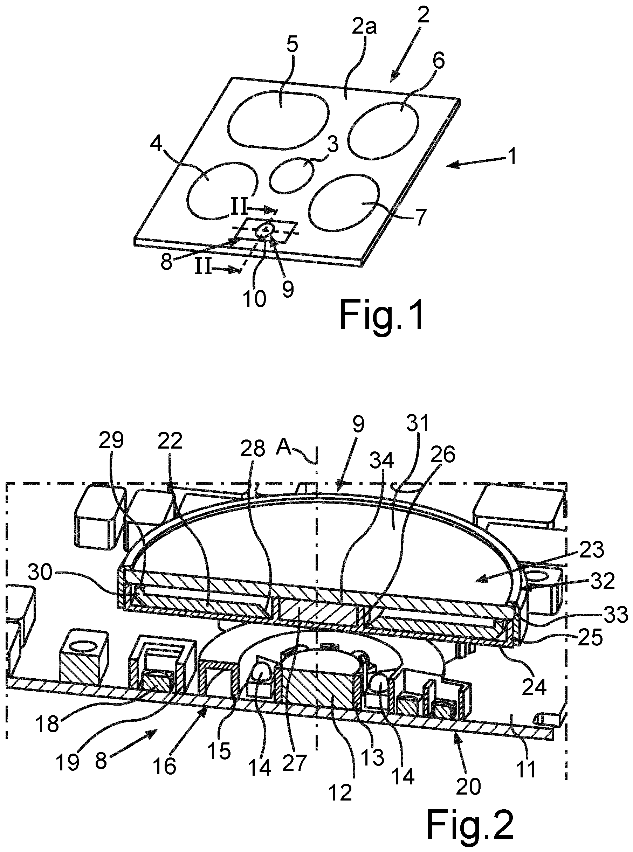

In Fig. 1 ist in einer schematischen Darstellung ein als Kochfeld 1 ausgebildetes Haushaltsgerät gezeigt. Das Kochfeld 1 umfasst eine als Haushaltsgeräteplatte ausgebildete Kochfeldplatte 2, die aus Glas oder Glaskeramik ausgebildet sein kann. Auf einer Oberseite 2a der Kochfeldplatte 2 sind in Anzahl, Position und Formgebung lediglich beispielhaft vier Kochzonen 3, 4, 5, 6 und 7 dargestellt.

Unter der Kochfeldplatte 2 sind in Fig. 1 nicht gezeigte Heizeinheiten angeordnet, um die Flächenbereiche der Kochzonen3 bis 7 beheizen zu können, wobei auf den Kochzonen 3 bis 7 Zubereitungsgefäße mit Speisen zur Zubereitung aufgestellt werden können. In dem Zusammenhang sind als Heizeinheiten beispielsweise sowohl Strahlungsheizkörper als auch Induktoren zu verstehen, bei denen entsprechend Energie zur Erwärmung der Speisen in Zubereitungsgefäßen eingebracht wird. Bei Induktoren werden, wie bekannt, die Kochzonen 3 bis 7 in Form des Materials der Kochfeldplatte nicht direkt aufgeheizt, sondern durch die elektromagnetische Wechselwirkung nur das Zubereitungsgefäß direkt erhitzt.

Das Kochfeld 1 umfasst darüber hinaus eine Bedienvorrichtung 8, welche im Ausführungsbeispiel im vorderen Bereich der Kochfeldplatte 2 angeordnet ist. Die Bedienvorrichtung 8 umfasst eine Bedienelementaufnahme 9, welche im Ausführungsbeispiel in der Kochfeldplatte 2 angeordnet ist. In der Bedienelementaufnahme 9 ist ein Bedienelement 10 positionierbar. Das Bedienelement 10 ist im Ausführungsbeispiel scheibenförmig oder diskusförmig ausgestaltet und zerstörungsfrei lösbar und wieder aufsetzbar auf die Kochfeldplatte 2, insbesondere die Bedienelementaufnahme 9, ausgebildet.

In Fig. 2 ist in einer Schnittdarstellung entlang der Schnittlinie II-II das Kochfeld 1 im Bereich der Bedienvorrichtung 8 gezeigt. Der Übersichtlichkeit dienend, und um die unter der Kochfeldplatte 2 angeordneten Komponenten ebenfalls zu erkennen, ist die Kochfeldplatte 2 in Fig. 2 nicht gezeigt.

Die Bedienvorrichtung 8 umfasst unter der Kochfeldplatte 2 einen Schaltungsträger 11, auf dem ein Haltemagnet 12 angeordnet ist. Der Haltemagnet 12 ist in einer Aufnahme 13 angeordnet, die als Trennwand 13 zumindest bereichsweise umlaufend um eine Achse A, die die Längsachse der Bedienvorrichtung und somit auch des Bedienelements 9 darstellt, angeordnet. In einer Richtung senkrecht zur Achse A und somit in radialer Richtung ist unmittelbar an dem Haltemagnet 12 und die Trennwand 13 anschließend eine Mehrzahl von Lichtquellen 14 positioniert. Die Lichtquellen 14 sind in Umlaufrichtung um die Achse A beabstandet und äquidistant zueinander angeordnet. Die Lichtquellen 14 sind vorzugsweise Leuchtdioden.

Wiederum radial nach außen anschließend an die Lichtquellen 14 ist eine weitere Wand 15 ausgebildet, die einer Einhausung komponentenspezifisch zugeordnet ist. Zu dieser Einhausung ist auch die innere Aufnahme 13 mit der gezeigten Wand zugehörig. Im Ausführungsbeispiel ist die Wand 15 Bestandteil eines umlaufenden Rings 16. Durch die Wand 15 beziehungsweise den Ring 16 wird eine Streulichtabschottung erreicht, so dass das Licht von den Lichtquellen 14 nicht unerwünscht seitlich nach außen strahlt. Die Bedienvorrichtung 8 umfasst darüber hinaus eine Infrarot-Sende-Empfangseinrichtung 17, die eine Mehrzahl, im Ausführungsbeispiel fünf, Sende-Empfangseinheiten 18 aufweist. Die Anzahl der Sende-Empfangseinheiten 18 entspricht der Anzahl an Kochzonen 3 bis 7. Die Sende-Empfangseinheiten 18 sind durch jeweils Einhausungen 19 (Fig. 2) ebenfalls seitlich entsprechend umgeben, so dass die Detektion verbessert ist und auch hier keine Streulichteffekte oder dergleichen einwirken können.

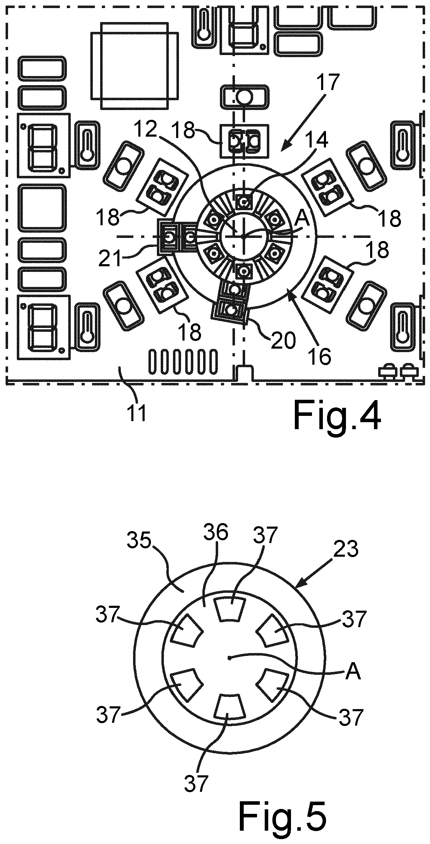

Darüber hinaus umfasst die Bedienvorrichtung 8 noch Detektoren 20 (Fig. 5) und 21, mittels welchen eine Dreherkennung des Bedienelements 9 um die Drehachse beziehungsweise Längsachse A relativ zur Oberseite 2a und somit auch zur Bedienelementaufnahme 10 erfassbar ist.

Wie aus der Darstellung in Fig. 2 des Weiteren zu erkennen ist, sind in vertikaler Richtung und somit in Richtung der Achse A betrachtet die Sende-Empfangseinheiten 18 innerhalb der Ausmaße des Bedienelements 9 angeordnet und insbesondere unter einem Lichtleiter 22 positioniert.

Der Lichtleiter 22 ist bedienelementintern angeordnet, wobei ein Gehäuse des Bedienelements 9 durch einen Deckel 23 und einen Boden 24 sowie eine Mantelwand 25 gebildet ist. Die Mantelwand 25 ist insbesondere einstückig mit dem Boden 24 ausgebildet. Auf der Innenseite des Bodens 25 ist darüber hinaus eine Aufnahme 26 für einen Haltemagneten 27, der im Bedienelement 9 angeordnet ist, ausgebildet. Der Haltemagnet 27 ist ebenfalls mittig zentral im Bedienelement 9 angeordnet und zur Wechselwirkung mit dem Haltemagneten 12 ausgebildet. Der Schaltungsträger 11 mit seinen darauf angeordneten Elementen, wie sie in Fig. 2 zu erkennen sind, ist unterhalb der Kochfeldplatte 2 angeordnet, wohingegen das Bedienelement 9 auf der Bedienelementaufnahme 10 über die Oberseite 2a anbringbar ist.

Der Lichtleiter 22 umfasst einen Lichteinkoppelbereich 28, der näherliegend zur Achse A angeordnet ist, als ein Lichtauskoppelbereich 29. Der Lichtleiter 22 ist als ringförmige Scheibe gestaltet, wobei an seinem der Achse A abgewandten radialen äußeren Ende ein nach oben sich erstreckender erhabener Steg 30 ausgebildet ist, der dann an seinem Ende den Lichtauskoppelbereich 29 bildet. Die Lichtquellen 14 sind in Richtung der Achse A betrachtet in geradliniger Verlängerung unter dem Lichteinkoppelbereich 28 ausgebildet.

Der Boden 24 ist vollflächig ausgebildet und deckt somit den Lichtleiter 22 von unten her vollständig ab. Das Licht der Lichtquellen 14 wird somit zunächst erst durch den Boden 24 und dann zum Lichteinkoppelbereich 28 abgestrahlt. Der Boden 24 ist vorzugsweise aus einem für Licht im für den Menschen sichtbaren Spektralbereich als auch für Infrarotstrahlen durchlässig. Insbesondere ist der Boden 24 aus einem Kunststoff, vorzugsweise PSU oder PESU ausgebildet.

Mittels der Infrarot-Sende-Empfangseinrichtung 17 und somit auch mit den Sende-Empfangseinheiten 18, die auf Basis der Detektion von Infrarotstrahlen arbeiten, ist eine Ausgestaltung ausgebildet, die zur Erfassung einer Auswahl einer Funktionsteileinheit des Kochfelds 1 ausgebildet ist. Insbesondere ist diese Einrichtung 17 dazu ausgebildet, die Auswahl einer Kochzone 3 bis 7 zu erfassen. Dazu ist jede der Infrarot-Sende-Empfangseinheiten 18 mit einer der Kochzonen 3 bis 7 bezüglich der gewünschten Auswahl verknüpft, was durch eine nicht gezeigte Steuereinheit dann erkannt und ausgewertet wird und die dann der jeweiligen Kochzone 3 bis 7 zugeordnete Heizeinheit aktiviert wird. In dem Zusammenhang ist es vorgesehen, dass ein Nutzer beispielsweise mit einem Finger auf eine Oberseite 31 des Deckels 23 örtlich spezifisch aufgreift beziehungsweise den Finger entsprechend auflegt, so dass dieses über die Infrarot-Sende-Empfangseinheiten 18 örtlich erkannt wird. Ist beispielsweise vorgesehen, dass die Kochzone 4 ausgewählt werden soll, so legt der Nutzer einen Finger auf die Oberseite 31 an der örtlich spezifizierten und vorgesehenen Fläche an der Oberseite 31 auf, die sich vertikal über der zugeordneten Infrarot-Sende-Empfangseinheit 18 befindet. Beispielsweise kann dies in dem Zusammenhang gemäß der Draufsichtdarstellung auf den Schaltungsträger 11 in Fig. 4 die linke untere Infrarot-Sende-Empfangseinheit 18 sein. Die in Umlaufrichtung um die Achse A, die gemäß Fig. 4 senkrecht zur Figurenebene verläuft, nachfolgende Infrarot-Sende-Empfangseinheit 18 ist dann der Kochzone 5 zugeordnet, wobei die dann in Umlaufrichtung der Achse A wiederum nachfolgende Infrarot-Sende-Empfangseinheit 18 der Kochzone 3 zugeordnet ist, die dann nachfolgende Infrarot-Sende-Empfangseinheit 18 der Kochzone 6 zugeordnet ist und die schließlich in Umlaufrichtung der Achse A in Fig. 4 rechts und vorn und unten angeordnete Infrarot-Sende-Empfangseinheit 18 der Kochzone 7 zugeordnet ist.

Der Deckel 23 ist im Ausführungsbeispiel aus einem chemisch gehärteten Glas ausgebildet und örtlich lokal lichtundurchlässig sowie an anderen örtlich lokalen Flächenbereichen für Licht im für den Menschen sichtbaren Spektralbereich und für Infrarotstrahlen durchlässig.

Darüber hinaus umfasst das Bedienelement 9 ein ringförmiges Abschlusselement 32, welches das Bedienelement 9 und somit auch die Mantelwand 25 umfangsseitig umgibt und auch einen Seitenrand 33 des Deckels 23 umgreift. Darüber hinaus umfasst dieses Abschlusselement 32 einen oberen Flansch beziehungsweise einen Auflagesteg 34, der auf der Oberseite 31 aufliegt. Vorzugsweise ist dieses Abschlusselement 32 aus Edelstahl oder Kunststoff ausgebildet.

Der Lichtleiter 22 ist mit seinem Auskoppelbereich 29 vollständig von dem Deckel 23 abgedeckt, wobei die Teilfläche des Deckels 23, welche in vertikaler Richtung über dem Lichtauskoppelbereich 29 angeordnet ist, für Licht im sichtbaren Spektralbereich und auch für Infrarotstrahlen durchlässig ist.

Zur Ausgestaltung der jeweiligen Teilflächen einer Unterseite 34 des Deckels 23 ist gemäß der Darstellung in Fig. 5, die eine Ansicht auf die Unterseite 34 des Deckels 23 zeigt, eine ringförmige Bedruckung oder eine Folie 35 vorgesehen, die für Licht im sichtbaren Spektralbereich und für Infrarotstrahlen durchlässig ist. Radial nach innen anschließend an diesen die Fläche der Unterseite 34 als äußerer umlaufender Ring bildenden Folie 35 ist ein bedruckter oder mit einer Folie versehener Bereich 36 ausgebildet, der für Infrarotstrahlen und Licht im sichtbaren Spektralbereich undurchlässig ist. In diesem Flächenbereich sind mehrere in Umlaufrichtung um die Achse A benachbart und beabstandet zueinander angeordnete Markierungen 37 ausgebildet, die insbesondere farblich weiß gestaltet sind. Durch diese Markierungen 37 wird mittels den Detektoren 20 und 21 die Drehrichtung um die Achse A ermittelt und daraus die gewünschte Einstellung eines Betriebsparameters der ausgewählten Funktionsteileinheit in Form der Kochzonen 3 bis 7 eingestellt. Insbesondere wird durch diese Drehrichtung und die Drehweite die Kochstufe der ausgewählten Kochzone 3 bis 7 eingestellt.

Die Markierungen 37 sind radial so positioniert, dass sie bei einem Drehen des Bedienelements 9 um die Achse A diese über den Detektoren 20 und 21 hinweg laufen und dadurch eher als die Drehrichtung und die gewünschte Wertmäßigkeit der Kochstufe erkannt und eingestellt wird. Dies ist insbesondere abhängig davon, wie viele derartige Markierungen 37 über zumindest einen Detektor 20, 21 hinweg beziehungsweise vorbei laufen.

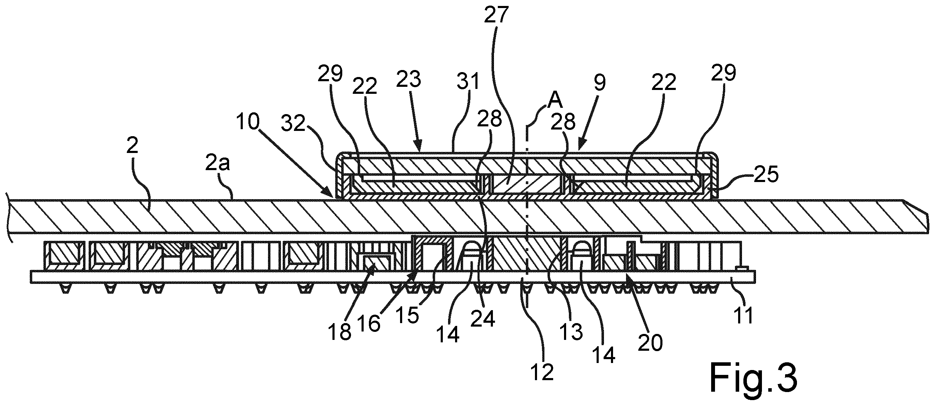

In Fig. 3 ist eine Schnittdarstellung der Fig. 2 gezeigt, wobei hier die Kochfeldplatte 2 mit aufgesetztem Bedienelement 9 dargestellt ist. Die relativen positionellen Anordnungen der einzelnen Komponenten des Bedienelements 9 und der bedienelementexternen Bauteile sowohl in Richtung der Achse A als auch in senkrechter Richtung dazu ist zu erkennen.

### Bezugszeichenliste

- 1: Haushaltsgerät
- 2: Kochfeldplatte
- 2a: Oberseite
- 3: Kochzone
- 4: Kochzone
- 5: Kochzone
- 6: Kochzone
- 7: Kochzone
- 8: Bedienvorrichtung
- 9: Bedienelementaufnahme
- 10: Bedienelement
- 11: Schaltungsträger
- 12: Haltemagnet
- 13: Trennwand
- 14: Lichtquelle
- 15: Wand
- 16: Ring
- 17: Sende-Empfangseinrichtung
- 18: Sende-Empfangseinheiten
- 19: Einhausungen
- 20: Detektor
- 21: Detektor
- 22: Lichtleiter
- 23: Deckel
- 24: Boden
- 25: Mantelwand
- 26: Aufnahme
- 27: Haltemagnet
- 28: Lichteinkoppelbereich
- 29: Lichtauskoppelbereich
- 30: Steg
- 31: Oberseite
- 32: Abschlusselement
- 33: Seitenrand
- 34: Unterseite
- 35: Folie
- 36: Bereich
- 37: Markierungen

- A: Achse
- II-II: Schnittlinie

## Patentansprüche

1. Bedienvorrichtung (8) für ein Haushaltsgerät (1), mit einem Bedienelement (9), welches an einer Bedienelementaufnahme (10) der Bedienvorrichtung (8) des mit der Bedienvorrichtung (8) steuerbaren Haushaltsgeräts (1) mittels Magnetkraft haltbar ist und relativ zur Bedienelementaufnahme (10) bewegbar und von dort abnehmbar positionierbar ist, und das Bedienelement (9) einen Lichtleiter (22) aufweist, welcher einen Lichteinkoppelbereich (28) aufweist, der einem seitlichen Rand des Bedienelements (9) ferner liegend angeordnet ist als ein Lichtauskoppelbereich (29) des Lichtleiters (22), wobei die Bedienvorrichtung (8) eine Infrarot-Sende-Empfangseinrichtung (17) zur Auswahl einer Funktionsteileinheit (3 bis 7) des Haushaltsgeräts (1) aufweist, die mit Sende-Empfangseinheiten (18) unter dem Lichtleiter (22) angeordnet und zur Detektion durch den Lichtleiter (22) hindurch ausgebildet ist,
und wobei Lichtquellen (14) bei Betrachtung in Richtung der Längsachse (A) des Bedienelements (9) in geradliniger Verlängerung unter einem Lichteinkoppelbereich (28) des Lichtleiters (22) angeordnet sind,
und wobei die Lichtquellen (14) in einem Ringkanal angeordnet sind, dessen Wände (13, 15) mit Höhen ausgebildet sind, die größer sind, als die Lichtquellenhöhen,
**dadurch gekennzeichnet, dass** die Wände (13, 15) an den den Lichtquellen (14) zugewandten Innenseiten reflektierend ausgebildet sind.

2. Bedienvorrichtung (8) nach Anspruch 1, **dadurch gekennzeichnet, dass** das Bedienelement (9) einen Boden (24) aufweist, durch welchen der Lichtleiter (22) von unten, insbesondere der Lichteinkoppelbereich (28), von unten abgedeckt ist.

3. Bedienvorrichtung (8) nach Anspruch 1 oder 2, **dadurch gekennzeichnet, dass** das Bedienelement (9) einen Boden (24) aufweist, der zumindest an den Bereichen, an denen das Licht für den Lichtleiter (22) einkoppelbar ist und an den Bereichen, an denen die Sende-Empfangseinheiten (18) durch den Lichtleiter (22) detektieren, für Licht im für den Menschen sichtbaren Spektralbereich und für den Infrarotbereich durchlässig ist.

4. Bedienvorrichtung (8) nach Anspruch 2 oder 3, **dadurch gekennzeichnet, dass** der Boden (24) aus einem Kunststoff, insbesondere Polysulfon oder Polyethersulfon, ist.

5. Bedienvorrichtung (8) nach einem der vorhergehenden Ansprüche, **dadurch gekennzeichnet, dass** der Lichtleiter (22) als ringscheibenförmiger Körper ausgebildet ist, an dessen äußeren Rand ein nach oben erhabener Steg (30) als Lichtauskoppelbereich (29) ausgebildet ist.

6. Bedienvorrichtung (8) nach einem der vorhergehenden Ansprüche, **dadurch gekennzeichnet, dass** das Bedienelement (9) eine Mantelwand (25) aufweist, durch welche der Lichtleiter (22) seitlich umlaufend abgedeckt ist und auf welcher ein Deckel (23) des Bedienelements (9) aufsitzt und/oder die Mantelwand (25) Licht undurchlässig ausgebildet ist.

7. Bedienvorrichtung (8) nach Anspruch 6, **dadurch gekennzeichnet, dass** die Sende-Empfangseinheiten (18) jeweils seitlich umlaufend zur Vermeidung der Streulichteinstrahlung eingehaust sind.

8. Bedienvorrichtung (8) nach einem der vorhergehenden Ansprüche, **dadurch gekennzeichnet, dass** das Bedienelement (9) einen Deckel (23) aufweist, der aus einem, insbesondere chemisch gehärteten, Glas ausgebildet ist.

9. Bedienvorrichtung (8) nach Anspruch 8, **dadurch gekennzeichnet, dass** an einer dem Lichtleiter (22) zugewandten Unterseite (34) des Deckels (23) eine Folie (35) oder eine Bedruckung aufgebracht ist, die für Infrarot und Licht im für den Menschen sichtbaren Spektralbereich durchlässig ist.

10. Bedienvorrichtung (8) nach Anspruch 8 oder 9, **dadurch gekennzeichnet, dass** der Deckel (23) an den Bereichen, die bei Betrachtung in Richtung der Längsachse (A) des Bedienelements (9) über einem Lichteinkoppelbereich (28) angeordnet sind, Licht undurchlässig ausgebildet ist.

11. Bedienvorrichtung (8) nach einem der vorhergehenden Ansprüche, **dadurch gekennzeichnet, dass** die Wände (13, 15) als eine Reflexionsfolie oder eine reflektierende Beschichtung ausgebildet ist.

12. Bedienvorrichtung (8) nach einem der vorhergehenden Ansprüche, **dadurch gekennzeichnet, dass** Lichtquellen (14), deren Licht in den Lichtleiter(22) eingekoppelt wird, in einem direkt an einen bedienelementexternen Haltemagnet (12) anschließenden Ringkanal um den Haltemagnet (12) herum angeordnet sind.

13. Haushaltsgerät, insbesondere Kochfeld (1), mit einer Bedienvorrichtung (8) nach einem der vorhergehenden Ansprüche.

## Claims

1. Operating device (8) for a household appliance (1), with an operating element (9), which can be held by means of magnetic force on an operating element receptacle (10) of the operating device (8) of the household appliance which can be controlled with the operating device and can be moved relative to the operating element receptacle (10) and can be positioned removably therefrom, and the operating element (9) has a light conductor (22) which has a light coupling-in area (28) which is arranged horizontally further on a lateral edge of the operating element (9) than a light coupling-out area (29) of the light conductor (22), wherein the operating device (8) has an infrared transmit-receive device (17) for selecting a functional subunit (3 to 7) of the household appliance (1) which is arranged with transmit-receive units (18) below the light conductor (22) and is embodied for detection through the light conductor (22),
and wherein when viewed in the direction of the longitudinal axis (A) of the operating element (9) light sources (14) are arranged in a straight extension below a light coupling-in area (28) of the light conductor (22),
and wherein the light sources (14) are arranged in an annular channel, the walls (13, 15) of which are embodied with heights which are larger than the light source heights, **characterised in that** the walls (13, 15) are embodied to be reflective on the inner sides facing the light sources (14).

2. Operating device (8) according to claim 1, **characterised in that** the operating element (9) has a base (24), by means of which the light conductor (22) is covered from below, in particular the light coupling-in area (28), from below.

3. Operating device (8) according to claim 1 or 2, **characterised in that** the operating element (9) has a base (24), which is permeable to light in the spectral range which is visible to humans and to the infrared range at least at the areas at which the light for the light conductor (22) can be coupled-in and at the areas at which the transmit-receive units (18) detect through the light conductor (22).

4. Operating device (8) according to claim 2 or 3, **characterised in that** the base (24) is made from a plastic, in particular polysulphone or polyethersulphone.

5. Operating device (8) according to one of the preceding claims, **characterised in that** the light conductor (22) is embodied as an annular disc-shaped body, at the outer edge of which an upwardly raised web (30) is embodied as a light coupling-out area (29).

6. Operating device (8) as claimed in one of the preceding claims, **characterised in that** the operating element (9) has a casing wall (25), by means of which the light conductor (22) is covered laterally peripherally and on which a cover (23) of the operating element (9) rests and/or the casing wall (25) is embodied to be impermeable to light.

7. Operating device (8) according to claim 6, **characterised in that** the transmit-receive units (18) are each housed laterally peripherally in order to avoid the stray light diffusion.

8. Operating device (8) according to one of the preceding claims, **characterised in that** the operating element (9) has a cover (23) which is embodied from an in particular chemically cured glass.

9. Operating device (8) according to claim 8, **characterised in that** a foil (35) or a printing is applied to an underside (34) of the cover (23) facing the light conductor (22) and is permeable to infrared and light in the spectral range which is visible to humans.

10. Operating device (8) according to claim 8 or 9, **characterised in that** at the regions which are arranged above a light coupling-in area (28) when viewed in the direction of the longitudinal axis (A) of the operating element (9), the cover (23) is embodied to be impermeable to light.

11. Operating device (8) according to one of the preceding claims, **characterised in that** the walls (13, 15) is embodied as a reflection foil or a reflective coating.

12. Operating device (8) according to one of the preceding claims, **characterised in that** light sources (14), the light of which is coupled into the light conductor (22), are arranged in an annular channel around the holding magnet (12) which adjoins a holding magnet (12) which is external to the operating element.

13. Household appliance, in particular hob (1), with an operating device (8) according to one of the preceding claims.

## Revendications

1. Dispositif de commande (8) pour un appareil ménager (1), avec un élément de commande (9), pouvant être maintenu par force magnétique dans un logement d'élément de commande (10) du dispositif de commande (8) de l'appareil ménager (1) pour être commandé avec le dispositif de commande (8) et pouvant être positionné de façon déplaçable par rapport au logement d'élément de commande (10) et amovible de cet endroit, et l'élément de commande (9) présente un conduit de lumière (22), lequel présente une zone de couplage de la lumière (28), disposée plus loin d'un bord latéral de l'élément de commande (9) qu'une zone de découplage de la lumière (29) du conduit de lumière (22), dans lequel le dispositif de commande (8) présente un dispositif d'émission-réception infrarouge (17) pour la sélection d'une unité partielle de fonctionnement (3 à 7) de l'appareil ménager (1), disposée avec des unités d'émission-réception (18) sous le conduit de lumière (22) et formée pour la détection à travers le conduit de lumière (22), et dans lequel des sources lumineuses (14) sont, vu en direction de l'axe longitudinal (A) de l'élément de commande (9), disposées en prolongement rectiligne sous une zone de couplage de la lumière (28) du conduit de lumière (22), et dans lequel les sources lumineuses (14) sont disposées dans un canal annulaire, dont les parois (13, 15) sont formées selon des hauteurs supérieures aux hauteurs des sources lumineuses, **caractérisé en ce que** les parois (13, 15) sont formées de façon réfléchissante sur les côtés intérieurs dirigés vers les sources lumineuses (14).

2. Dispositif de commande (8) selon la revendication 1, **caractérisé en ce que** l'élément de commande (9) présente un fond (24) qui couvre le conduit de lumière (22), en particulier la zone de couplage de la lumière (28), par le bas.

3. Dispositif de commande (8) selon la revendication 1 ou 2, **caractérisé en ce que** l'élément de commande (9) présente un fond (24) translucide dans la plage spectrale visible à l'œil humain et à la plage infrarouge au moins dans les zones auxquelles la lumière peut être couplée pour le conduit de lumière (22) et dans les zones auxquelles les unités d'émission-réception (18) détectent à travers le conduit de lumière (22).

4. Dispositif de commande (8) selon la revendication 2 ou 3, **caractérisé en ce que** le fond (24) est en un plastique, en particulier le polysulfone ou le polyéthersulfone.

5. Dispositif de commande (8) selon l'une des revendications précédentes, **caractérisé en ce que** le conduit de lumière (22) est formé sous la forme d'un corps en forme de disque annulaire, sur le bord extérieur duquel une âme (30) en relief vers le haut (30) est formée sous forme de zone de découplage de la lumière (29).

6. Dispositif de commande (8) selon l'une des revendications précédentes, **caractérisé en ce que** l'élément de commande (9) présente une paroi d'enveloppe (25), qui couvre le conduit de lumière (22) en l'entourant latéralement et sur laquelle un couvercle (23) de l'élément de commande (9) repose et/ou la paroi d'enveloppe (25) est exécutée de façon opaque.

7. Dispositif de commande (8) selon la revendication 6, **caractérisé en ce que** les unités d'émission-réception (18) sont respectivement abritées latéralement sur le pourtour afin d'éviter l'irradiation de lumière diffusée.

8. Dispositif de commande (8) selon l'une des revendications précédentes, **caractérisé en ce que** l'élément de commande (9) présente un couvercle (23) formé en un verre, en particulier durci chimiquement.

9. Dispositif de commande (8) selon la revendication 8, **caractérisé en ce qu'**un film (35) ou une impression perméable aux infrarouges et à la lumière dans la plage spectrale visible à l'œil humain est apposé(e) sur un côté inférieur (34) du couvercle (23) dirigé vers le conduit de lumière (22).

10. Dispositif de commande (8) selon la revendication 8 ou 9, **caractérisé en ce que** le couvercle (23) est formé de façon opaque dans les zones disposées, vu en direction de l'axe longitudinal (A) de l'élément de commande (9), au-dessus d'une zone de couplage de la lumière (28).

11. Dispositif de commande (8) selon l'une des revendications précédentes, **caractérisé en ce que** les parois (13, 15) sont formées sous la forme d'un film de réflexion ou d'un revêtement réfléchissant.

12. Dispositif de commande (8) selon l'une des revendications précédentes, **caractérisé en ce que** les sources lumineuses (14) dont la lumière est couplée dans le conduit de lumière (22), sont disposées dans un conduit annulaire directement contigu à l'aimant de maintien (12) externe à l'élément de commande, autour de l'aimant de maintien (12).

13. Appareil ménager (1), en particulier champ de cuisson (1), avec un dispositif de commande (8) selon l'une des revendications précédentes.
